# EUROPEAN PATENT APPLICATION

(11) **EP 4 756 877 A1**
(43) Date of publication of application: **10.06.2026**
(21) Application number: 24849651.5
(22) Date of filing: 02.08.2024
(51) Int. Cl.: H01L 25/075, H10H 20/857, H10H 20/85, H10H 29/01, H10D 86/00

(54) **LIGHT-EMITTING ELEMENT AND LIGHT-EMITTING DEVICE COMPRISING SAME**

(30) Priority: 03.08.2023 US 202363530483 P; 30.01.2024 US 202463626646 P; 01.08.2024 US 202418791790
(71) Applicant: Seoul Viosys Co., Ltd., Ansan-si, Gyeonggi-do 15429 (KR)
(72) Inventor: LEE, Chung Hoon, Ansan-Si Gyeonggi-do 15429 (KR); KO, Mi So, Ansan-Si Gyeonggi-do 15429 (KR); CHOI, Eun Mi, Ansan-Si Gyeonggi-do 15429 (KR)
(74) Representative: Stolmár & Partner Patentanwälte PartG mbB
(86) International application number: PCT/KR2024/011389
(87) International publication number: WO 2025/029084

(57) **Abstract**

The disclosed technology relates to a light emitting device and a light emitting apparatus having the same.

The disclosed technology discloses a light emitting apparatus 10 including a substrate 100 and a plurality of light emitting devices 200 disposed on the substrate 100, and at least one substrate common electrode 110 and a plurality of substrate individual electrodes 120 formed on the substrate 100, wherein N light emitting devices 200₁~200_{N} (N is a natural number greater than or equal to 2) are commonly connected to the substrate common electrode 110 to form a light emitting group G.

## Description

### [Technical Field]

The disclosed technology relates to a light emitting device and a light emitting apparatus having the same.

### [Background Art]

As one of light emitting apparatuses, a display apparatus is an apparatus that displays characters, symbols, images, videos, or others. The display apparatus may include a plurality of light emitting devices, and may display characters, symbols, images, videos, or others by controlling light emitted from the plurality of light emitting devices.

The display apparatus includes a display substrate, such as a PCB substrate, on which electric circuits are disposed, and the plurality of light emitting devices may be modularized and disposed on the display substrate.

In conventional display apparatuses, there were cases where characters, symbols, images, videos, or others were not smoothly displayed because the plurality of light emitting devices was not securely and reliably connected to the display substrate. In particular, when a defect such as some of the light emitting devices falling off from the display substrate occurs, a region where the corresponding light emitting devices are installed may become a dead pixel, which may cause the display quality to deteriorate.

### [Disclosure]

### [Technical Problem]

The purpose of the disclosed technology is to provide a light emitting device and a light emitting apparatus having the same, which simplifies the circuit connection structure for a plurality of light emitting devices, reduces electrical resistance, and improves the reliabililty of the light emitting devices by addressing heat generation issues.

### [Technical Solution]

A light emitting apparatus 10 according to an embodiment of the disclosed technology may include a substrate 100 and a plurality of light emitting devices 200 disposed on the substrate 100.

In an embodiment, the light emitting apparatus 10 may include at least one substrate common electrode 110 and a plurality of substrate individual electrodes 120 formed on the substrate 100.

In an embodiment, N light emitting devices 200₁~200_{N} (N is a natural number greater than or equal to 2) may be commonly connected to the substrate common electrode 110 to form a light emitting group G.

In an embodiment, a number of the substrate common electrodes 110 may be equal to a number of the light emitting groups G.

In an embodiment, each of the plurality of light emitting devices 200 may include K light emitting units 210₁~210_{K} (K is a natural number greater than or equal to 2).

A common electrode 220 commonly connected to the K light emitting units 210₁~210_{K} and a plurality of individual electrodes 230 connected to each of the K light emitting units 210₁~210_{K} may be included.

In an exemplary embodiment, a number of light emitting units emitting light in a first light emitting device among the plurality of light emitting devices may be different from a number of light emitting units emitting light in at least one other light emitting device among the plurality of light emitting devices.

In an embodiment, the N may be greater than or equal to the K.

In an embodiment, a number of the plurality of individual electrodes 230 may be K.

In an embodiment, the N may be greater than the K and less than or equal to twice the K.

In an embodiment, the K light emitting units 210₁~210_{K} may emit light of a same peak wavelength.

In an embodiment, characteristics of light emitted from the first light emitting device among the plurality of light emitting devices may be different from characteristics of light emitted from at least one other light emitting device among the plurality of light emitting devices.

In an embodiment, when a same current is supplied to the first light emitting device and a second light emitting device among the plurality of light emitting devices, a current density of the light emitting unit emitting light in the first light emitting device may be different from that of a light emitting unit emitting light in the second light emitting device.

In an embodiment, at least one of the K light emitting units 210₁~210_{K} may emit light with a peak wavelength different from at least one other light emitting unit 210₁~210_{K}.

In an embodiment, the N light emitting devices 200₁~200_{N} may be disposed to surround the substrate common electrode 110 with the substrate common electrode 110 as a center.

In an embodiment, the N light emitting devices 200₁~200_{N} may be disposed with virtual extension lines V as a boundary, which are radially branched from the substrate common electrode 110 as a center.

In an embodiment, the N light emitting devices 200₁~200_{N} may have a polygonal shape in plan view, and virtual lines IM connecting vertices positioned farthest from the substrate common electrode 110 among vertices of the light emitting devices 200₁~200_{N} may form a triangle, a square, a pentagon or a hexagon in plan view.

In an embodiment, at least a portion of a region formed by virtual lines IM connecting edges positioned farthest from the substrate common electrode 110 among edges of the light emitting devices 200₁~200_{N} may be overlapped with the light emitting devices 200₁~200_{N} of an adjacent light emitting group G in plan view.

In an embodiment, each of the light emitting devices 200 may include K light emitting units 210₁~210_{K} (K is a natural number greater than or equal to 2), and a first common electrode 240 commonly connected to the K light emitting units 210₁~210_{K}.

In an embodiment, the light emitting units 210₁~210_{K} may be dispersed at a distance spaced apart from a one point on the first common electrode 240 in the radial direction from the one point. The one point may be a center point of the first common electrode.

In an embodiment, the light emitting units 210₁~210_{K} may have a shape having at least one vertex, respectively, and each of the light emitting units 210₁~210_{K} may be disposed such that the at least one vertex is directed toward the one point on the first common electrode.

In an embodiment, the at least one vertices of the light emitting units 210₁~210_{K} directed toward the one point may be spaced apart from one another.

In an embodiment, each of the light emitting devices 200 may include K light emitting units 210₁~210_{K}) (K is a natural number greater than or equal to 2), and the K light emitting units 210₁~210_{K}.

In an embodiment, the light emitting units 210₁~210_{K} may have a shape having at least one vertex, respectively, and each of the light emitting units 210₁~210_{K} may be disposed such that the at least one vertex is directed toward one point
In an embodiment, the at least one vertices of the light emitting units 210₁~210_{K} directed toward the one point may be spaced apart from one another.

In an embodiment, the one point may be formed on an extension line connecting at least two or more vertices of the light emitting units 210₁~210_{K}.

In an embodiment, the light emitting device 200 may further include a second common electrode 250 commonly connected to the K light emitting units 210₁~ 210_{K}.

In an embodiment, the K light emitting units 210₁~210_{K} may be connected in parallel between the first common electrode 240 and the second common electrode 250.

In an embodiment, S light emitting devices 200₁~200_{S} may form one pixel PX.

In an embodiment, at least one of the S light emitting devices 200₁~200_{S} may emit light having a peak wavelength different from that of other light emitting devices.

In an embodiment, the pixel PX is provided in a plurality of numbers, and an intensity of light having a first peak wavelength emitted from light emitting devices 200₁~200_{S} included in at least one of the plurality of pixels PX may be different from that of light having the first peak wavelength emitted from light emitting devices 200₁~200_{S} included in other pixel PX.

In an embodiment, the pixel PX is provided in a plurality of numbers, and a number of the light emitting devices 200₁~200_{S} emitting light having a first peak wavelength included in at least one of the plurality of pixels PX may be different from that of light emitting devices 200₁~200_{S} emitting light having the first peak wavelength included in other pixel PX.

### [Advantageous Effects]

The disclosed technology may provide a light emitting device and a light emitting apparatus having the same, which simplifies the circuit connction structure for a plurality of light emitting devices, reduces electrical resistance, and improves the reliablilty of the light emitting devices by addressing heat generation issues.

The disclosed technology may provide a light emitting device and a light emitting apparatus having the same, which decreases the movement of the light emission center point due to variations in the light emitting area or number of a plurality of light emitting devices, thereby ensuring a uniform position of the light emission center point.

### [Description of Drawings]

FIG. 1A is a front view showing a light emitting device according to an embodiment of the disclosed technology.
FIG. 1B is a modification of FIG. 1.
FIG. 2 is a plan view showing a light emitting apparatus according to a first embodiment of the disclosed technology.
FIG. 3 is a plan view showing a light emitting apparatus according to a second embodiment of the disclosed technology.
FIG. 4 is a plan view showing a light emitting apparatus according to a third embodiment of the disclosed technology.
FIG. 5 is a plan view showing a light emitting apparatus according to a fourth embodiment of the disclosed technology.
FIG. 6 is a plan view showing a display apparatus according to an embodiment of the disclosed technology.
FIG. 7 is a plan view showing a display apparatus according to another embodiment of the disclosed technology.
FIG. 8 is a plan view showing a light emitting apparatus according to a fifth embodiment of the disclosed technology.
FIG. 9 is a plan view showing a light emitting apparatus according to a sixth embodiment of the disclosed technology.
FIGs. 10A to 10C are plan views showing light emitting apparatuses according to a seventh to ninth embodiments of the disclosed technology.

### [Best Mode]

In the following description, for the purposes of explanation, numerous specific details are set forth in order to provide thorough understanding of various exemplary embodiments or implementations of the present disclosure. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. For example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), and the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

The disclosed technology discloses a light emitting apparatus 10 including a substrate 100 and a plurality of light emitting devices 200 disposed on the substrate 100.

The substrate 100 is a substrate on which a plurality of light emitting devices 200 is mounted and can be configured in various ways. The substrate 100 is a substrate on which the light emitting device 200 is mounted on an upper surface thereof, and is not limited to a specific type as long as it can support the light emitting device 200, such as a circuit board, a lead frame, a flexible substrate, a transparent substrate, or others.

For example, the substrate 100 may be configured with a PCB (Printed Circuit Board). The PCB may be, for example, an FR4 PCB which has excellent characteristics such as high strength, flame retardancy, chemical resistance, and the like. Alternatively, it may be a metal PCB (Metal Printed Circuit Board) with excellent heat dissipation performance and favorable thermal conductivity. In more detail, it may be a PCB including Cu, Zn, Au, Ni, Al, Mg, Cd, Be, W, Mo, Si and Fe or an alloy of at least one of these as a base metal. However, the inventive concepts are not limited thereto, and various PCBs may be used depending on product characteristics.

The substrate 100 has an insulation layer and an interconnection for electrical connection with the light emitting device 200, and may include circuits for supplying and driving an electrical source such as current or voltage to the light emitting device 200.

An electrode pad for mounting the light emitting device 200 may be formed on the upper surface of the substrate 100, and a pad for mounting on another substrate (for example, a display substrate) may be formed on a lower surface of the substrate 100.

The substrate 100 may be formed in a single-layer or multi-layer structure, and may be formed in various thicknesses as needed.

The substrate 100 may be a display substrate configuring a display apparatus 1000 which will be described below, or a display
The plurality of light emitting devices 200 may be disposed on one surface of the substrate 100. The plurality of light emitting devices 200 may be connected to an electric circuit of the substrate 100 by a conductive material or an adhesive material. For example, the plurality of light emitting devices 200 may be connected to the electric circuit of the substrate 100 by soldering.

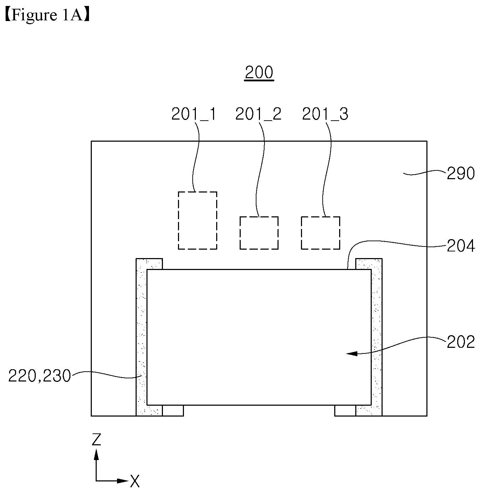

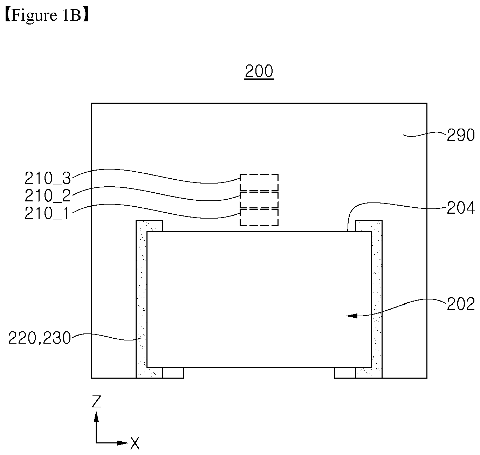

FIG. 1 is a front view of a light emitting device 200 according to an embodiment of the disclosed technology, and hereinafter, a detailed configuration of the light emitting device 200 mounted on one surface of a substrate 100 will be described with reference to FIG. 1.

The light emitting device 200 is configured to include a light emitting diode that receives power from the outside and emits light, and can be configured in various ways.

Specifically, the light emitting device 200 may include a base 202 and K light emitting units 210₁~210_{K} (K is a natural number greater than or equal to 2) disposed on one surface of the base 202.

The base 202, as a support structure that supports the K light emitting units 210₁~210_{K}, can have various configurations.

In addition, the light emitting device 200 may be supported by being coupled to the base 202, and may include electrodes 220 and 230 for electrical connection with the K light emitting units 210₁~210_{K}.

The electrodes 220 and 230 may be formed of a conductive material, and may include Ti, W, Ni, Pd, Al, Au, Sn, Cu, Sr, PbO, PbSO₄ or at least one material among superconducting materials.

The electrodes 220 and 230 may include a chemical formula of AₐB_{b}(EO₄)_{c}X_{d}, A: (s-, p-block metal) Ca, Ba, Sr, Sn, Pb, (lanthanides, or others) Y, La, Ce or a combination of at least one of materials, B: (d-block metal) Cu, Cd, Zn, Mn, Fe, Ni, Ag or a combination of at least one of materials, E: P, As, V, Si, B, S or a combination of at least one of materials, X: F, Cl, OH, O, S, Se, Te or a combination of at least one of materials (a: 0 ~ 10, b: 0 ~ 10, c: 0 ~ 6, d: 0 ~ 4).

The electrodes 220 and 230 may include a ceramic compound, or may include Lanarkite. The electrodes 230, 240, and 250 may include any one of a region including Pb₂SO₅, a region including PbS, a region including CuP or a region including PbS.

The electrodes 220 and 230 may have a resistance value of 10⁻⁷Ω·cm or less.

In addition, the light emitting device 200 may further include a molding member 290 covering the K light emitting units 210₁~210_{K}. The molding member 290 may be omitted as an optional configuration.

The molding member 290 may be configured as a member through which light emitted from the K light emitting units 210₁~210_{K} is transmitted while protecting the K light emitting units 210₁~210_{K}.

The molding member 290 may cover the K light emitting units 210₁~210_{K} and an upper surface 204 of the base 202, and may even cover at least portions of the electrode 220 and 230.

The molding member 290 may encapsulate the K light emitting units 210₁~210_{K}, and may also function as a refraction layer that refracts light emitted therefrom.

The molding member 290 may be configured as a single layer or a plurality of layers, and may be a transparent molding for transmitting light emitted from the light emitting units 210₁~210_{K}.

Meanwhile, the molding member 290 may be formed of a resin including at least one of, for example, acrylate, silicone, epoxy, PMMA (Polymethyl methacrylate), and PS (Polystyrene) series, without being limited thereto. In addition, the molding member 290 may be formed of a fluorine resin to improve an extraction efficiency of light emitted from the light emitting units 210₁~210_{K}.

In addition, the molding member 290 may be a light-transmitting layer formed of a material that light can transmit. A light transmittance rate of the molding member 290 may be 50% or more, preferably 70% or more. In this case, a light blocking rate of the molding member 290 may be 40% or less.

As another example, the molding member 290 may further include a light reflective material or a light absorbing material. In this case, the molding member 290 may be an opaque layer, and may adjust a contrast of a display by including black pigment. In addition, the molding member 290 may include a matrix having a light scattering material such as silica.

As another example, the molding member 290 may perform both a light-blocking function and a light-reflecting function. For example, the molding member 290 may be formed of a carbon black molding agent or a molding agent combined with black and white.

As another example, the molding member 290 may further include a light-absorbing function in addition to the light-reflecting function. For example, the molding member 290 may be formed of a white molding agent or a molding agent combined with white and black. Accordingly, a contrast of light emitted through the molding member 290 may be adjusted, and a brightness of the display may be improved.

As another example, the molding member 290 may further include a light diffusing material capable of diffusing light emitted from the light emitting units 210₁~210_{K}, and for example, the light diffusing material may include one or more of TiO₂, BaO, SiO₂, and MgO, Y₂O₃ capable of scattering light, which may be distributed inside the molding member 400.

A thickness of the molding member 290 may be configured in various ways.

The K light emitting units 210₁~210_{K} are light emitting diodes that emit light when power is applied, and can be configured in various ways. FIG. 1 illustrates an example in which the light emitting device 200 includes three light emitting units 210_1, 210_2, and 210_3 (that is, K=3), but the inventive concepts are not limited thereto.

Each of the light emitting units 210₁~210_{K} is a light emitting structure grown on one surface of a growth substrate, and may include a first conductivity type semiconductor layer, an active layer, and a second conductivity type semiconductor layer.

The growth substrate is a substrate on which a semiconductor layer is disposed, and is not limited to any substrate on which a nitride-based semiconductor can be disposed. For example, the growth substrate may include a heterogeneous substrate, such as a sapphire substrate, a gallium arsenide substrate, a silicon substrate, a silicon carbide substrate or a spinel substrate, and may also include a homogeneous substrate, such as a gallium nitride substrate, an aluminum nitride substrate, or others.

The first conductivity type semiconductor layer is a semiconductor layer disposed on one surface of the growth substrate, and a buffer layer may be further disposed between the first conductivity type semiconductor layer and the growth substrate. The buffer layer may include a nitride or phosphide semiconductor, such as GaN, GaAs, or others, and may be grown using MOCVD.

The buffer layer may improve crystallinities of semiconductor layers disposed on the growth substrate in a subsequent process, and may also serve as a seed layer on which the nitride-based semiconductor layers may be grown on the heterogeneous substrate.

The first conductivity type semiconductor layer may include a phosphide- or nitride-based semiconductor such as (Al, Ga, In)P or (Al, Ga, In)N, and may be disposed on the growth substrate using a method such as MOCVD, MBE, HVPE, or others. In addition, the first conductivity type semiconductor layer may be doped as n-type by including one or more impurities such as Si, C, Ge, Sn, Te, Pb, or others. However, the inventive concepts are not limited thereto, and the first conductivity type semiconductor layer may be doped with an opposite conductivity type, including a p-type dopant.

In addition, furthermore, the first conductivity type semiconductor layer may be formed of a single layer or multiple layers. For example, the first conductivity type semiconductor layer may be configured with a first sub-conductivity type semiconductor layer and a second sub-conductivity type semiconductor layer over the first sub-conductivity type semiconductor layer.

The first sub-conductivity type semiconductor layer and the second sub-conductivity type semiconductor layer may be doped at different concentrations from each other, and formed at different process temperatures from each other. When the first conductivity type semiconductor layer is formed of the multiple layers, the first conductivity type semiconductor layer may include a superlattice layer.

Furthermore, the first conductivity type semiconductor layer may further include a contact layer, a modulation doping layer, an electron injection layer, and others.

The active layer is a light emitting layer formed over the first conductivity type semiconductor layer, which may include a phosphide or nitride semiconductor such as (Al, Ga, In)P or (Al, Ga, In)N, and may be grown on the first conductivity type semiconductor layer using a method such as MOCVD, MBE, HVPE, or others.

In addition, the active layer may include a quantum well (QW) structure including at least two barrier layers and at least one well layer, and further, may include a multi quantum well (MQW) structure including a plurality of barrier layers and a plurality of well layers.

A wavelength of light emitted from the active layer may be adjusted by controlling a composition ratio of materials configuring the well layer. In this case, the well layer may commonly include a same element, and may include In.

The well layer is positioned between the barrier layers, and a band gap energy of the well layer may be smaller than that of the barrier layer. The well layer may include InₓGo(₁₋ₓ₎N or InₓGo₍₁₋ₓ₎P (0 < x < 1) or may be formed with one of these. And the wavelength of the light emitted may be controlled depending on a composition ratio (x) of In.

The barrier layers and well layers are alternately stacked, and it is preferable that they are alternately stacked at least twice. Adjacent barrier layers and well layers may form a pair.

The second conductivity type semiconductor layer may be a semiconductor layer formed on the active layer. The second conductivity type semiconductor layer may include a phosphide- or nitride-based semiconductor such as (Al, Ga, In)P or (Al, Ga, In)N, and may be grown using a technique such as MOCVD, MBE, or HVPE. The second conductivity type semiconductor layer may be doped with a conductivity type opposite to that of the first conductivity type semiconductor layer. For example, the second conductivity type semiconductor layer 126 may be doped as p-type including an impurity such as Mg.

The second conductivity type semiconductor layer may be formed as a single layer having a composition similar to that of p-GaN, but is not limited thereto, and may further include an AlGaN layer inside.

In addition, the light emitting units 210₁~210_{K} may be configured to include an insulation layer covering the first conductivity type semiconductor layer and the second conductivity type semiconductor layer and forming an opening in which first and second electrode pads are disposed. The first and second electrode pads may be an n-type electrode pad and a p-type electrode pad, respectively.

The first and second electrode pads may be electrically connected to the first conductivity type semiconductor layer and the second conductivity type semiconductor layer through the opening in the insulation layer, respectively.

The above-mentioned light emitting units 210₁~210_{K} may be implemented by being modified into various structures, and it is obvious that they may be modified into various structures such as a flip-chip type, a vertical type, and a lateral type.

As an example, the K light emitting units 210₁~210_{K} may all emit light of a same peak wavelength. As another example, at least one of the K light emitting units 210₁~210_{K} may emit light with a peak wavelength different from those of other light emitting units 210₁~210_{K}. Exemplarily, the K light emitting units 210₁~210_{K} may all emit light with peak wavelengths different from one another. In other words, the K light emitting units 210₁~210_{K} may all emit light of a same color. Alternatively, at least one of the K light emitting units 210₁~210_{K} may emit light of a color different from those of the other light emitting units 210₁~210_{K}. Exemplarily, the K light emitting units 210₁~210_{K} may all emit light of colors different from one another.

Specifically, one of the K light emitting units 210₁~210_{K} is a light emitting diode emitting blue light (B), which may be a blue light emitting diode having a peak wavelength within a blue wavelength range, and the blue light emitting diode may have a difference between the peak wavelength and a dominant wavelength of 2 nm to 15 nm. Specifically, the blue light emitting diode may have the peak wavelength between 430 nm and 475 nm, and may have the dominant wavelength between 460 nm and 480 nm. The peak wavelength of the blue light emitting diode may be shorter than that of the dominant wavelength.

As another example, one of the K light emitting units 210₁~210_{K} is a light emitting diode emitting green light (G), which may be a green light emitting diode having a peak wavelength within a green wavelength range, and the green light emitting diode may have a difference between the peak wavelength and a dominant wavelength of 5 to 20 nm. Specifically, the green light emitting diode may have the peak wavelength between 510 nm and 540 nm, and may have the dominant wavelength between 525 nm and 545 nm. The peak wavelength of the green light emitting diode may be shorter than that of the dominant wavelength.

As another example, one of the K light emitting units 210₁~210_{K} is a light emitting diode emitting red light (R), which may be a red light emitting diode having a peak wavelength within a red wavelength range, and the red light emitting diode may have a difference between the peak wavelength and a dominant wavelength of 5 to 30 nm. Specifically, the red light emitting diode may have the peak wavelength between 620 nm and 640 nm, and may have the dominant wavelength between 600 nm and 630 nm. The peak wavelength of the red light emitting diode may be longer than that of the dominant wavelength.

In a case that each of the K light emitting units 210₁~210_{K} emits blue light, green light or red light, one pixel PX that displays RGB primary colors may be configured.

When the light emitting device 200 includes three first to third light emitting units 210_1, 210_2, and 210_3, the first light emitting unit 210_1 may emit red light, which is light having a longest peak wavelength, the second light emitting unit 210_2 may emit green light, which is light having a peak wavelength shorter than that of the first light emitting unit 210_1, and the third light emitting unit 210_3 may emit blue light, which is light having a shortest peak wavelength. The first light emitting unit 210_1 emitting light with the longest peak wavelength may have a height of its upper surface higher than heights of upper surfaces of the second light emitting unit 210_2 and the third light emitting unit 210_3. That is, a vertical length of the first light emitting unit 210_1 may be longer than vertical lengths of the second light emitting unit 210_2 and the third light emitting unit 210_3.

The light emitting units 210₁~210_{K} may have a thickness of 250 µm or less, which may be a thickness including the first conductivity type semiconductor layer, the active layer, the second conductivity type semiconductor layer, and the growth substrate.

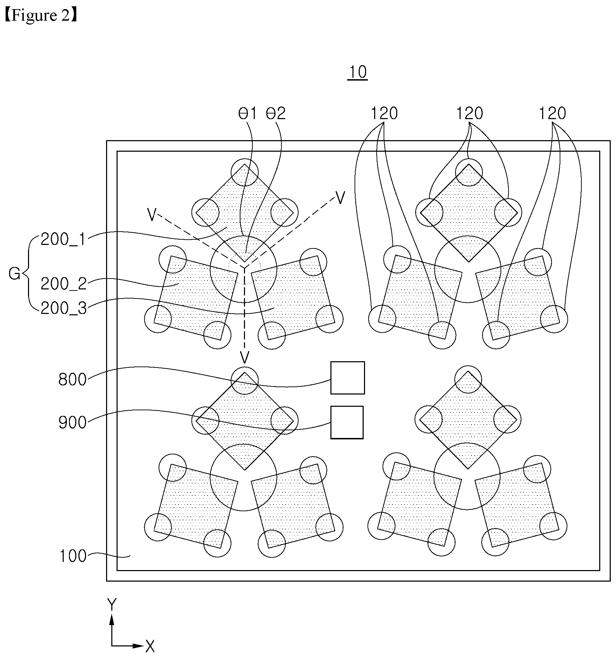

The K light emitting units 210₁~210_{K} may be laterally spaced apart and arranged side by side as illustrated in FIG. 1, without being limited thereto. That is, the K light emitting units 210₁~210_{K} may be a stacked light emitting diode that is vertically stacked and disposed as illustrated in FIG. 2.

Meanwhile, the K light emitting units 210₁~210_{K} may be connected to the electrodes 220 and 230 and receive power from a power source. In this case, the electrodes 220 and 230 may be provided in a plurality of numbers.

For example, the electrodes 220 and 230 may include a common electrode 220 commonly connected to the K light emitting units 210₁~210_{K}, and a plurality of individual electrodes 230 respectively connected to the K light emitting units 210₁~210_{K}.

Since the light emitting device 200 include the K light emitting units 210₁~210_{K}, the electrodes 220 and 230 may include one or more common electrodes 220 and K individual electrodes 230. That is, a number of the plurality of individual electrodes 230 may be equal to the number K of the light emitting units 210₁~210_{K}. For example, when the light emitting device 200 includes three light emitting units 210_1, 210_2, and 210_3, the electrodes 220 and 230 may be provided in a total of four, including one common electrode 220 and three individual electrodes 230.

Meanwhile, the light emitting device 200 may have a polygonal shape in plan view. For example, the light emitting device 200 may be configured in a shape having vertices forming acute or obtuse angles, such as a square, rectangle, rhombus, pentagon, hexagon, diamond shape, or the like in plan view. Light may be focused at vertices of the light emitting device 200 that form the acute angles, thereby allowing light to be emitted farther.

As illustrated in FIG. 2, the light emitting apparatus 10 may include a plurality of light emitting devices 200 disposed on a substrate 100.

Among the plurality of light emitting devices 200, N light emitting devices 200₁~200_{N} (N is a natural number greater than or equal to 2) may form a light emitting group G. The light emitting apparatus 10 may include a plurality of light emitting groups G.

In this case, the light emitting apparatus 10 may include at least one substrate common electrode 110 and a plurality of substrate individual electrodes 120 formed on the substrate 100.

The substrate common electrode 110 may be an electrode commonly connected to the plurality of light emitting devices 200. As an example, the substrate common electrode 110 may be commonly connected to first conductivity type semiconductor layers of the plurality of light emitting devices 200. As another example, the substrate common electrode 110 may be commonly connected to second conductivity type semiconductor layers of the plurality of light emitting devices 200.

The substrate individual electrode 120 may be an electrode connected to each individual light emitting device 200. When the substrate common electrode 110 is connected to the first conductivity type semiconductor layer of the light emitting device 200, the substrate individual electrode 120 may be connected to the second conductivity type semiconductor layer of the light emitting device 200. When the substrate common electrode 110 is connected to the second conductivity type semiconductor layer of the light emitting device 200, the substrate individual electrode 120 may be connected to the first conductivity type semiconductor layer of the light emitting device 200.

The N light emitting devices 200₁~200_{N} may be connected to the substrate common electrode 110 through the common electrode 220, and may be connected to each substrate individual electrode 120 through each individual electrode 230.

As an example, when three light emitting devices 200_1, 200_2, and 200_3 configure one light emitting group G, and each light emitting device 200_1, 200_2, or 200_3 includes three light emitting units 210_1, 210_2, and 210_3 (in this case, a total of nine light emitting units 210 are included in one light emitting group G), the common electrode 220 commonly connected to the three light emitting units 210_1, 210_2, and 210_3 and the first conductivity type semiconductor layer may be connected to the substrate common electrode 110, and the individual electrodes 230 connected to the second conductivity type semiconductor layers of the light emitting units 210_1, 210_2, and 210_3 may be respectively connected to the substrate individual electrodes 120. On the contrary, a manner is also possible in which the common electrode 220 commonly connected to the three light emitting units 210_1, 210_2, and 210_3 and the second conductivity type semiconductor layer is connected to the substrate common electrode 110, and the individual electrodes 230 connected to the first conductivity type semiconductor layers of the light emitting units 210_1, 210_2, and 210_3 are respectively connected to the substrate individual electrodes 120. Accordingly, by applying power to the substrate common electrode 110 and the substrate individual electrode 120, each light emitting device 200 and each light emitting unit 210 belonging to one light emitting group G may be driven independently.

When a number of the light emitting devices 200 configuring one light emitting group G is N, the substrate common electrode 110 may be provided in a number of one or more, and the substrate individual electrode 120 may be provided in a number of 2*N or more. When the number of the light emitting units 210 included in the light emitting device 200 is K, the substrate individual electrodes 120 may be provided in a number of K*N or more.

One substrate common electrode 110 is disposed for each light emitting group G, and thus, a number of the substrate common electrodes 110 may be equal to a number of the light emitting groups G, but the inventive concepts are not limited thereto.

The number of the light emitting devices 200 connected to one substrate common electrode 110 may be configured in various ways. As an example, the number of the light emitting devices 200 connected to the one substrate common electrode 110 may be greater than or equal to a number of individual electrodes 230 included in one light emitting device 200.

An upper area of the substrate common electrode 110 may be larger than an area of at least one substrate individual electrode 120. Accordingly, heat generation may be reduced by reducing an increase in resistance even when a plurality of light emitting devices 200₁~200_{N} is electrically connected to one substrate common electrode 110.

When one light emitting group G is provided with one substrate common electrode 110, the number N of the light emitting devices 200 configuring one light emitting group G may be greater than or equal to the number K of the light emitting units 210 (or the number of the individual electrodes 230) included in one light emitting device 200. Alternatively, the number N of the light emitting devices 200 configuring one light emitting group G may be greater than the number K of the light emitting units 210 (or the number of the individual electrodes 230) included in one light emitting device 200 and less than 2*K.

Through this, a circuit for driving the light emitting unit 210 of each light emitting device 200 may be simplified, thereby preventing a short circuit due to interference between circuits and preventing a resistance increase.

The light emitting group G may be provided in a plurality of numbers, and the substrate common electrode 110 may be provided in a number corresponding to that of the light emitting groups G. The substrate common electrode 110 may be spaced apart on the substrate 100 and disposed in various patterns such as a grid, a honeycomb, or others.

The substrate common electrode 110 and the substrate individual electrode 120 configuring one light emitting group G may be formed in various sizes and shapes, and disposed in various forms.

As an example, the N light emitting devices 200₁~200_{N} configuring one light emitting group G may be disposed to surround the substrate common electrode 110 with the substrate common electrode 110 as a center. Accordingly, the plurality of substrate individual electrodes 120 may be disposed along a periphery with the substrate common electrode 110 as the center.

As the substrate common electrode 110 is positioned in a central portion, each of the light emitting devices 200₁~200_{N} may be disposed toward the central portion, that is, a center of the substrate common electrode 110. In this case, even when the light emitting devices 200₁~200_{N} have a step due to a mesa structure, the common electrodes 220 are disposed to gather at the center of the substrate common electrode 110, and thus, it is possible to alleviate a deviation due to height difference of the light emitting devices 200₁~200_{N} (to provide stability against height difference) and prevent a viewing angle from being distorted.

In addition, referring to FIG. 2, when virtual extension lines V branched radially from a center point of the substrate common electrode 110 are formed, each of the N light emitting devices 200₁~200_{N} configuring one light emitting group G may be disposed between two extension lines, with the extension lines as a boundary.

A number of the extension lines is equal to the number N of the light emitting devices 200₁~200_{N}, and assuming the virtual extension lines V that are evenly branched radially with the substrate common electrode 110 as the center, central angles Θ1, Θ2, ad Θ3 between the extension lines V may be equal to 360°/N.

In this case, the N light emitting devices 200₁~200_{N} configuring one light emitting group G may be disposed with the virtual extension lines V as the boundary, which are evenly branched radially from the substrate common electrode 110 of the substrate as the center.

However, in the disclosed technology, the central angles Θ1, Θ2, and Θ3 of the extension lines V are not limited to a case where they are equally branched, and as an example, when the number of the light emitting devices 200₁~200_{N} is 3, the central angles Θ1, Θ2, and Θ3 between adjacent extension lines V may be in a range of 110°to 130°.

Meanwhile, the central angles Θ1, Θ2, and Θ3 between the adjacent extension lines V may be greater than an angle of the vertice of the light emitting devices 200₁~200_{N} facing the center point of the substrate common electrode 110. Through this, the light emitting devices 200₁~200_{N} may be spaced apart appropriately and a sufficient space may be secured for installation.

The N light emitting devices 200₁~200_{N} may have a polygonal shape in plan view, and as an example, may have a square shape in plan view as illustrated in FIG. 2.

In this case, virtual lines IM connecting vertices positioned farthest from the substrate common electrode 110 among the vertices of the light emitting devices 200₁~200_{N} may form a triangle, a square, or a pentagon in plan view. As an example, as illustrated in FIG. 2, the virtual lines IM may form a triangle.

Through an arrangement in which the light emitting devices 200₁~200_{N} are disposed, the disclosed technology may adjust a shape of a lighting pattern and a shape of light spreading.

As an example, the light emitting devices 200₁~200_{N} may be disposed as illustrated in FIG. 2, so that the shape of the lighting pattern or the shape of light spreading may be implemented in a non-circular shape. Each of the light emitting devices 200₁~200_{N} may be formed as a shape having at least one vertex, for example, an N-gon, a rhombus, a trapezoid, or the like. The light emitting devices 200₁~200_{N} may be disposed such that at least one vertex of each thereof is directed toward one central portion.

Meanwhile, although not shown in the drawings, the light emitting apparatus 10 may further include a conductive material connecting the electrodes 110 and 120 of the substrate 100 and the light emitting device 200. The conductive material may be positioned between the electrodes 110 and 120 and the light emitting device 200.

An area of a lower surface of the conductive material in contact with an upper surface of the substrate common electrode 110 may be larger than that of the lower surface of the conductive material in contact with an upper surface of at least one substrate individual electrode 120. Through this, a connection between the electrodes 110 and 120 of the substrate 100 and the light emitting device 200 may be enhanced.

In the light emitting apparatus 10, at least one of the plurality of light emitting devices 200 may have a number of light emitting devices 200₁~200_{N} turned on that is different from a number of light emitting devices 200₁~200_{N} turned on in the other light emitting devices 200. Alternatively, in the light emitting apparatus 10, at least one of the plurality of light emitting devices 200 may have optical characteristics different from optical characteristics emitted from the other light emitting devices 200. The optical characteristics may be any one of a viewing angle, a viewing pattern, a light emission pattern, a light emission intensity, or a spectrum. In the light emitting apparatus 10, at least one of the plurality of light emitting devices 200 may be turned on when any of the other light emitting devices 200 cannot be turned on. Accordingly, even when one of the light emitting devices 200 becomes difficult to be turned on, a normal display may be implemented without additional rework.

However, the purpose and the effect of the disclosed technology are not limited thereto, and the disclosed technology may increase or decrease a luminous intensity value of at least one of the plurality of light emitting devices 200 in a situation where a clearer display implementation is required.

Meanwhile, at least one IC driver 800 may be electrically connected to the substrate 100, and may control on/off and a luminous intensity adjustment of the light emitting devices 200. The light emitting apparatus 10 may further include a sensor 900 that is disposed on the substrate 100 and detects a luminous intensity of each color of the light emitting devices 200. The sensor 900 may detect the luminous intensity and provide a signal to the IC driver 800 to supplement the luminous intensity to the light emitting devices 200.

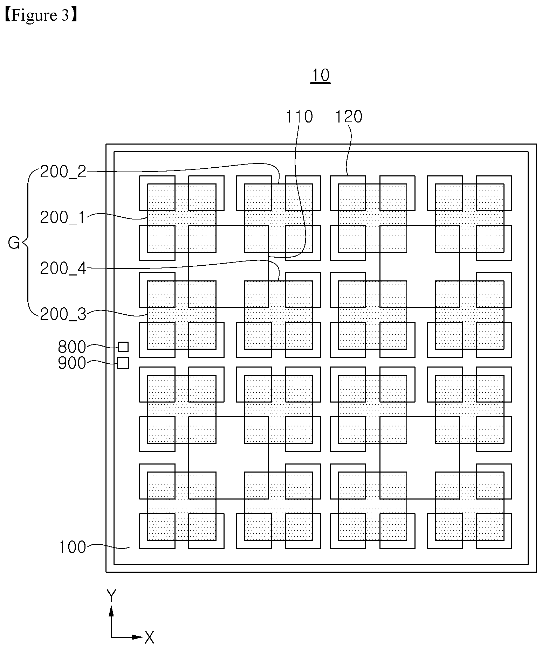

Next, FIG. 3 is a plan view showing a light emitting apparatus 10 according to another embodiment, and a same or similar configuration as that of the light emitting apparatus 10 of FIG. 2 will not be described redundantly, but differences from the light emitting apparatus 10 of FIG. 2 will be described in detail.

FIG. 3 shows a case where four light emitting devices 200_1, 200_2, 200_3, and 200_4 configure one light emitting group G, and in FIG. 3, a plurality of light emitting devices 200 may be disposed in a matrix form. A spacing between adjacent light emitting devices 200_1, 200_2, 200_3, and 200_4 within one light emitting group G may be smaller than a spacing between adjacent light emitting devices 200_1, 200_2, 200_3, and 200_4 within different adjacent light emitting groups G.

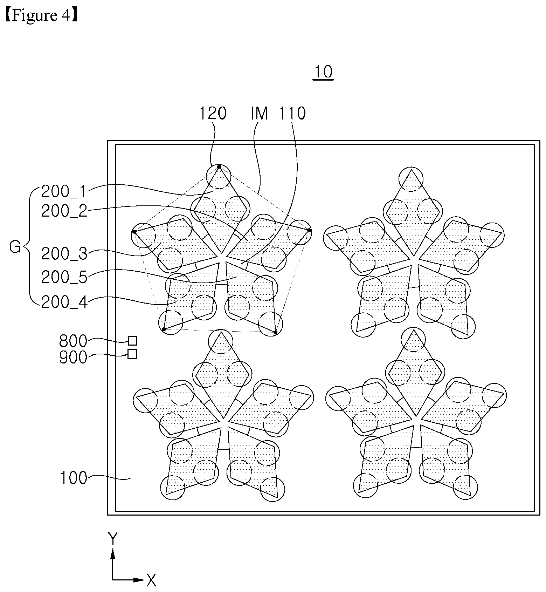

Next, FIG. 4 is a plan view showing a light emitting apparatus 10 according to another embodiment, and a same or similar configuration as that of the light emitting apparatus 10 of FIG. 2 and FG. 3 will not be described redundantly, but differences from the light emitting apparatus 10 of FIG. 2 and FIG. 3 will be described in detail.

FIG. 4 shows a case where five light emitting devices 200_1, 200_2, 200_3, 200_4, and 200_5 configure one light emitting group G, referring to FIG. 4, the light emitting devices 200_1, 200_2, 200_3, 200_4, and 200_5 may have a rhombus or a diamond shape in plan view, and in this case, virtual lines IM connecting vertices positioned farthest from a substrate common electrode 110 among vertices of the light emitting devices 200_1, 200_2, 200_3, 200_4, and 200_5 may form a pentagon in plan view.

Through an arrangement in which the light emitting devices 200₁~200_{N} are disposed, the disclosed technology may adjust a shape of a lighting pattern and a shape of light spreading.

As an example, the light emitting devices 200₁~200_{N} may be disposed as illustrated in FIG. 4, so that the shape of the lighting pattern or the shape of light spreading may be implemented in a shape similar to a pentagon rather than a circle.

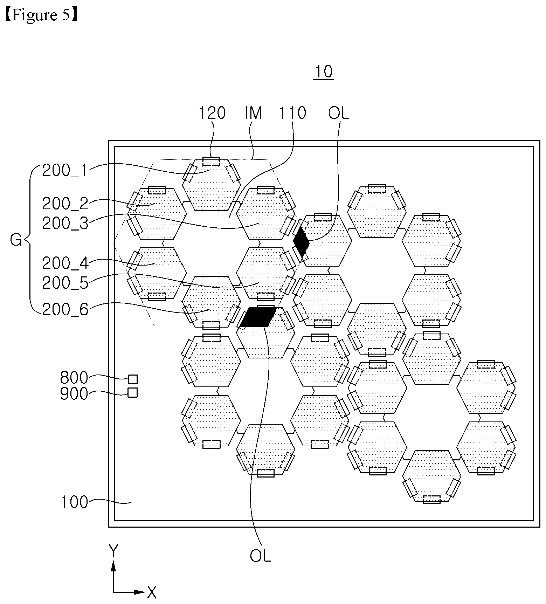

Next, FIG. 5 is a plan view showing a light emitting apparatus 10 according to another embodiment, and a same or similar configuration as that of the light emitting apparatus 10 of FIGs. 2, 3 and 4 will not be described redundantly, but differences from the light emitting apparatus 10 of FIGs. 2, 3 and 4 will be described in detail.

FIG. 5 shows a case where six light emitting devices 200_1, 200_2, 200_3, 200_4, 200_5, and 200_6 configure one light emitting group G, referring to FIG. 5, the light emitting devices 200_1, 200_2, 200_3, 200_4, 200_5, and 200_6 may have a hexagonal shape in plan view, and in this case, virtual lines IM connecting vertices positioned farthest from a substrate common electrode 110 among vertices of the light emitting devices 200_1, 200_2, 200_3, 200_4, and 200_5 may form a hexagon in plan view.

Through an arrangement in which the light emitting devices 200₁~200_{N} are disposed, the disclosed technology may adjust a shape of a lighting pattern and a shape of light spreading.

As an example, the light emitting devices 200₁~200_{N} may be disposed as illustrated in FIG. 5, so that the shape of the lighting pattern or the shape of light spreading may be implemented in a shape similar to a hexagon rather than a circle.

In addition, virtual lines IM connecting edges positioned farthest from the substrate common electrode 110 among edges of the light emitting devices 200_1, 200_2, 200_3, 200_4, and 200_5 may form a hexagonal shape.

In this case, at least a portion of a hexagonal shaped region formed by the virtual lines IM may be overlapped with at least portions of light emitting devices 200₁~200_{N} of a different adjacent light emitting group G, so that an overlapping region OL may be formed. Through this, the light emitting devices 200₁~200_{N} may be grouped at high density and disposed.

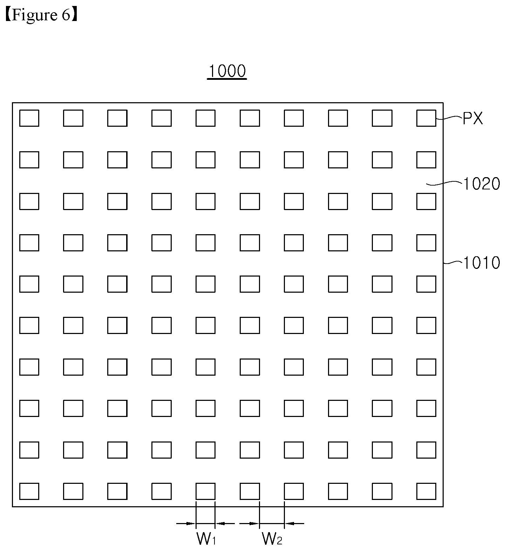

Meanwhile, FIG. 6 is a plan view showing a display apparatus 1000 to which the light emitting apparatus 10 according to the disclosed technology is applied. The display apparatus 1000 may include a display panel, and may be applied to signage or display apparatuses, vehicles, or others.

The display apparatus 1000 may include a circuit board 1010, a plurality of pixels PX disposed on the circuit board 1010, and a buffer layer 1020.

The circuit board 1010 is a panel substrate, and may include circuits for passive matrix driving or active matrix driving. In an embodiment, the circuit board 1010 may include interconnection lines and resistors therein. In another embodiment, the circuit board 1010 may include interconnection lines, transistors and capacitors. The circuit board 1010 may also have pads disposed on its upper surface to allow electrical connection to circuits disposed therein.

The plurality of pixels PX may be arranged on the circuit board 1010. The pixel PX may be a small light emitting apparatus 10 having a micro-scale size. A first direction width W1 of the pixel PX may have a size of 1000 µm or less. In an embodiment, a distance W2 between adjacent pixels PX in a first direction in which the pixels PX are arranged may be wider than the width W1 of the pixels PX in the first direction. Alternatively, in another embodiment, for adjusting pixels, the distance W2 between the pixels PX in the first direction in which the pixels PX are arranged may be disposed to be narrower than the width W1 of the pixels PX in the first direction. Each pixel PX may include a plurality of light emitting devices 200. For example, the pixel PX may include blue, green, and red subpixels.

The buffer layer 1020 may cover the circuit board 1010 between the pixels PX, and may cover upper surfaces of the pixels PX. The buffer layer 1020 may also include a matrix that is transparent to light, but the inventive concepts are not limited thereto.

For example, the buffer layer 1020 may reflect light or absorb light, and for this purpose, a matrix with light reflection characteristics or a matrix with light absorption characteristics may be used. Alternatively, the buffer layer 1020 may contain a light absorbing material such as carbon black or a light scattering material such as silica within the matrix.

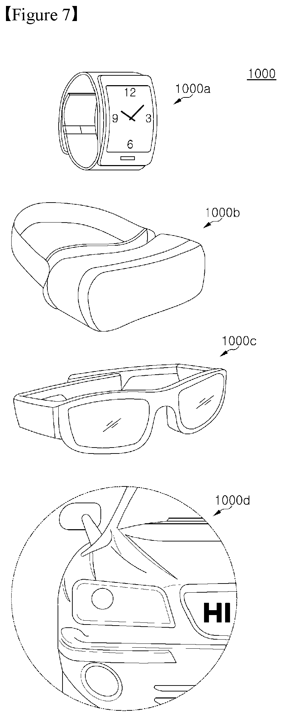

In addition, referring to FIG. 7, the light emitting apparatus 10 according to the disclosed technology may be applied to a VR display apparatus such as a smart watch 1000a or a VR headset 1000b, an AR display apparatus such as augmented reality glasses 1000c, or a display apparatus such as signage or others. Alternatively, it may be applied to a display of a vehicle 1000d and configured to implement icons such as character strings (English, numbers, Korean, or others) or pictures. The display apparatus may be networked with an external source to implement user-specified characters or icons. The external source may be an application or a system setting mounted in the vehicle.

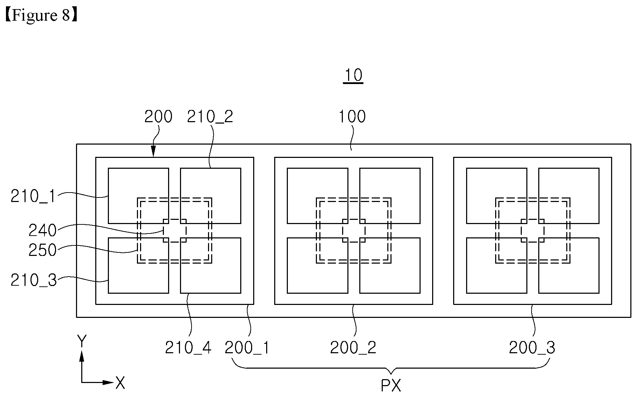

Next, FIGs. 8 to 10 are plan views showing a light emitting apparatus 10 according to other embodiments of the disclosed technology, which may configure the pixel PX of the display apparatus 1000 of FIG. 6 or FIG. 7.

Specifically, the light emitting apparatus 10 may include a substrate 100 and a plurality of light emitting devices 200 disposed on the substrate 100. In this case, the light emitting device 200 may include K light emitting units 210₁~210_{K} (K is a natural number greater than or equal to 2) and a first common electrode 240 commonly connected to the K light emitting units 210₁~210_{K}.

The K light emitting units 210₁~210_{K} may be configured identically or similarly to the configuration described in FIGs. 1 to 5, and thus, a detailed description thereof is omitted.

The light emitting apparatus 10 may include S light emitting devices 200₁~200_{S}, and the S light emitting devices 200₁~200_{S} may form one pixel PX. As an example, referring to FIG. 8, the light emitting apparatus 10 may form one pixel PX by including three light emitting devices 200_1, 200_2, and 200_3. A width or length of one pixel PX may be less than 10um. Alternatively, an area of one pixel PX may be 100um² or less.

Herein, the S light emitting devices 200₁~200_{S} may emit light with different peak wavelengths from one another. At least one of the S light emitting devices 200₁~200_{S} is light emitting devices 200₁~200_{S} emitting red light which may be a subpixel of red light. At least one of the S light emitting devices 200₁~200_{S} is light emitting devices 200₁~200_{S} emitting blue light which may be a subpixel of blue light. At least one of the S light emitting devices 200₁~200_{S} is light emitting devices 200₁~200_{S} emitting green light which may be a subpixel of green light.

The K light emitting units 210₁~210_{K} included in each of the light emitting devices 200₁~200_{S} may correspond to light emitting cells. Since each of the light emitting devices 200₁~200_{S} configuring the subpixels includes K light emitting cells, a possibility that each subpixel includes a defect may be reduced, and reliability of the device may be increased even when a high current is supplied to the light emitting cells. An XRD rocking curve 102 value of at least one light emitting cell may be less than 110°. In this case, the light emitting cells may have various shapes such as lateral type light emitting diodes, flip-chip type light emitting diodes, vertical type light emitting diodes, or others, without being limited to a specific structure.

Each of the light emitting devices 200₁~200_{S} which is the subpixel includes the K light emitting units 210₁~210_{K} as a plurality of light emitting cells, and in this case, the plurality of light emitting cells may be separated by a separation region.

The separation region may be formed in such a manner that the substrate supporting the light emitting cells is exposed, or that partial regions of a semiconductor layer configuring the light emitting cells are separated and disposed and the partial regions of the semiconductor layer are disposed between the light emitting cells.

The separation region may be 50 nm or more. Side surfaces of the light emitting cells facing each other by the separation region may have an inclination. A side inclination of the light emitting cells facing each other is formed at an angle of 50°or more with respect to an upper surface of the substrate, which may improve light extraction efficiency.

A number K of the light emitting device 200, that is, the light emitting units 210₁~210_{K} included in the subpixel K may be 2 or greater. That is, a number of light emitting cells included in the subpixel may be two or more. The light emitting cells may be disposed in a matrix form with rows and columns, or may be arranged side by side in a row.

Lengths of the light emitting cells may be less than a length of the subpixel divided by the number of cells. A maximum length of one edge included in the light emitting cell may be 5 um or less. Alternatively, an area of one light emitting cell may be less than 50 um².

The first common electrode 240 is an electrode commonly connected to the light emitting units 210₁~210_{K}, and may be connected to first conductivity type semiconductor layers or second conductivity type semiconductor layers of the K light emitting units 210₁~210_{K}.

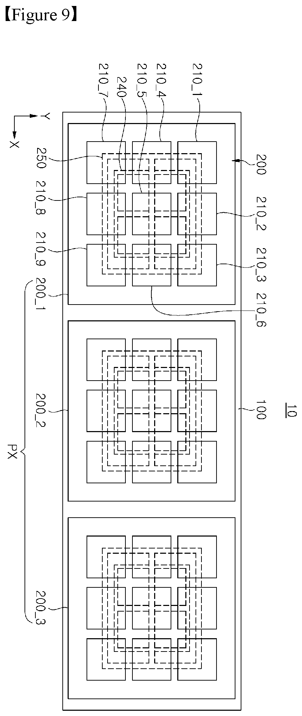

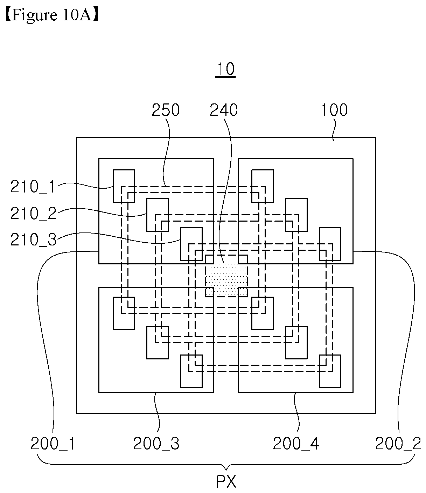

In this case, a number of the first common electrodes 240 may be equal to a number S of the light emitting devices 200. Referring to FIGs. 8 and 9, the first common electrode 240 may be individually provided for each light emitting device 200, so that it may be provided in three, which is a same number as the number of light emitting devices 200. Alternatively, the number of the first common electrodes 240 may be less than the number S of the light emitting devices 200. That is, at least one of the first common electrodes 240 may be shared by adjacent light emitting devices 200. Referring to FIGs. 10A to 10C, it can be seen that since at least portions of the first common electrodes 240 are shared by adjacent light emitting devices 200, the number of the first common electrodes 240 is provided in a number less than a total number of light emitting devices 200.

In this case, the light emitting device 200 may further include a second common electrode 250. When the first common electrode 250 is connected to first conductivity type semiconductor layers of the light emitting units 210₁~210_{K}, the second common electrode 250 may be connected to second conductivity type semiconductor layers. On the contrary, when the first common electrode 250 is connected to the second conductivity type semiconductor layers, the second common electrode 250 may be connected to the first conductivity type semiconductor layers.

As an example, the second common electrode 250 may further include a second common electrode 250 commonly connected to the K light emitting units 210₁~210_{K}. Referring to FIGs. 8 and 9, the second common electrode 250 is an electrode commonly connected to the light emitting units 210₁~210_{K}, and may be connected to the first conductivity type semiconductor layers or second conductivity type semiconductor layers of the K light emitting units 210₁~210_{K}. As a result, the K light emitting units 210₁~210_{K} may be connected in parallel between the first common electrode 240 and the second common electrode 250.

Specifically, in FIG. 8, each of the light emitting devices 200_1, 200_2, and 200_3 includes four light emitting cells, that is, four light emitting units 210_1, 210_2, 210_3, and 210_4, and may be disposed in a square matrix form (2x2). In this case, the first common electrode 240 is provided in a same number as that of the light emitting devices 200_1, 200_2, and 200_3, and each of them is disposed in a central region of the four light emitting units 210_1, 210_2, 210_3, and 210_4, so that it may be shared with the four light emitting units 210_1, 210_2, 210_3, and 210_4. The second common electrode 250 is provided in a same number as that of the light emitting devices 200_1, 200_2, and 200_3, and each of them may be a circulation electrode that sequentially connects through the four light emitting units 210_1, 210_2, 210_3, and 210_4. The circulation electrode may have a square ring or circular ring shape, without being limited to a specific shape. The second common electrode 250 may be disposed to surround the first common electrode 240 in the outside of the first common electrode 240.

In FIG. 8, the K light emitting cells included in one subpixel (a light emitting device 200) may be connected in parallel between the first and second common electrodes 240 and 250, and accordingly, even when one light emitting cell is not turned on, other light emitting cells may be normally turned on without being affected by this.

Optical characteristics of at least one subpixel (a light emitting device 200) and optical characteristics of other subpixels (light emitting devices 200) may be different from each other. The optical characteristics may be any one of a viewing angle, a viewing pattern, a light emission pattern, a light emission, or a spectrum. An electrical signal supplied to each of the K light emitting cells that are turned on in the one subpixel (the light emitting device 200) compared to an electrical signal supplied to at least one sub-pixel ( a light emitting device 200) may have a value different from an electrical signal supplied to each of the K light emitting cells that are turned on in the other subpixels (the light emitting devices 200) compared to an electrical signal supplied to different at least one other subpixel (a light emitting device 200). The electrical signal may be current, voltage, power or resistance.

Referring back to FIG. 8, a number of light emitting units 210_1, 210_2, 210_3, and 210_4 that are turned on in at least one light emitting device 200_1, 200_2, or 200_3 among the three light emitting devices 200_1, 200_2, and 200_3 may be different from a number of light emitting units 210_1, 210_2, 210_3, and 210_4 that are turned on in other light emitting devices 200_1, 200_2, and 200_3.

Meanwhile, the pixels PX may be provided in a plurality of numbers. When power is applied to the light emitting apparatus 10, an intensity of light having a first peak wavelength emitted from light emitting devices 200₁~200_{S} included in at least one of the plurality of pixels PX may be different from that of light having the first peak wavelength emitted from light emitting devices 200₁~200_{S} included in other pixel PX.

In addition, when power is applied to the light emitting apparatus 100, a number of the light emitting units 210₁~210_{K} emitting light having the first peak wavelength in the light emitting devices 200₁~200_{S} included in the at least one of the plurality of pixels PX may be different from that of the light emitting units 210₁~210_{K} emitting light having the first peak wavelength in the light emitting devices 200₁~200_{S} included in the other pixel PX.

In addition, when power is applied to the light emitting apparatus 100, a driving voltage applied to the light emitting units 210₁~210_{K} emitting light having the first peak wavelength in the light emitting devices 200₁~200_{S} included in the at least one of the plurality of pixels PX may be different from a driving voltage applied to the light emitting units 210₁~210_{K} emitting light having the first peak wavelength in the light emitting devices 200₁~200_{S} included in the other pixels PX.

In an embodiment, each of the light emitting devices 200 may include K light emitting units 210₁~210_{K} (K is a natural number greater than or equal to 2), and the K light emitting units 210₁~210_{K}.

In an embodiment, the light emitting units 210₁~210_{K} may have a shape having at least one vertex, respectively, and each of the light emitting units 210₁~210_{K} may be disposed such that the at least one vertex is directed toward one point.

In an embodiment, the at least one vertices of the light emitting units 210₁~210_{K} directed toward the one point may be spaced apart from one another.

In an embodiment, the one point may be formed on an extension line connecting at least two or more vertices of the light emitting units 210₁~210_{K}.

FIG. 9 is a modified example of the light emitting apparatus 10 of FIG. 8, and differences from the light emitting apparatus 10 of FIG. 8 will be described. The light emitting apparatus 10 illustrates an embodiment in which light emitting devices 200_1, 200_2, and 200_3 which are one subpixel, include nine light emitting cells, that is, light emitting units 210_1, 210_2, 210_3, 210_4, 210_5, 210_6, 210_7, 210_8, and 210_9, respectively. A maximum length of one edge of each light emitting cell may be less than 3 um.

The light emitting cells 210_1, 210_2, 210_3, 210_4, 210_5, 210_6, 210_7, 210_8, and 210_9 may be disposed in a 3x3 matrix form, and accordingly, may include one central light emitting cell 210_5 disposed at a center thereof. Remaining light emitting cells 210_1, 210_2, 210_3, 210_4, 210_6, 210_7, 210_8, and 210_9 may be peripheral light emitting cells surrounding the central light emitting cell 210_5. Each of the light emitting cell 210_1, 210_2, 210_3, 210_4, 210_5, 210_6, 210_7, 210_8, and 210_9 may be separated by a separation region.

In this case, a number of first common electrodes 240 may be equal to a number S of the light emitting devices 200. Referring to FIG. 9, the first common electrode 240 is individually provided for each light emitting device 200, so that three, which is a same number as that of light emitting devices 200, may be provided.

In this case, the light emitting device 200 may further include a second common electrode 250. When the first common electrode 250 is connected to first conductivity type semiconductor layers of the light emitting units 210₁~210_{K}, the second common electrode 250 may be connected to second conductivity type semiconductor layers. On the contrary, when the first common electrode 250 is connected to the second conductivity type semiconductor layers, the second common electrode 250 may be connected to the first conductivity type semiconductor layers.

Referring to FIG. 9, the second common electrode 250 is an electrode that is commonly connected to the nine light emitting units 210_1, 210_2, 210_3, 210_4, 210_5, 210_6, 210_7, 210_8, and 210_9 included in one light emitting device 200, and may be connected to the first conductivity type semiconductor layers or second conductivity type semiconductor layers of the light emitting units 210_1, 210_2, 210_3, 210_4, 210_5, 210_6, 210_7, 210_8, and 210_9. Accordingly, the nine light emitting units 210_1, 210_2, 210_3, 210_4, 210_5, 210_6, 210_7, 210_8, and 210_9 may be connected in parallel between the first common electrode 240 and the second common electrode 250.

Specifically, in FIG. 9, each of the light emitting devices 200_1, 200_2, and 200_3 includes nine light emitting cells, that is, the nine light emitting units 210_1, 210_2, 210_3, 210_4, 210_5, 210_6, 210_7, 210_8, and 210_9, and may be disposed in the 3x3 matrix form. In this case, the first common electrode 240 is provided in a same number as that of the light emitting devices 200_1, 200_2, and 200_3, and each of them may be shared with the nine light emitting units 210_1, ..., 210_9. The second common electrode 250 is provided in a same number as that of the light emitting devices 200_1, 200_2, and 200_3, and each of them may be shared with the nine light emitting units 210_1, ..., 210_9.

The first common electrode 240 and the second common electrode 250 may be circulation electrodes that sequentially connect through the nine light emitting units 210_1, ..., 210_9.

Specifically, the central light emitting cell and the peripheral light emitting cells may be electrically connected to one another by the first common electrode 240 and the second common electrode 250.

The first common electrode 240 may include a first circulation electrode passing through the peripheral light emitting cells and a first connection electrode connecting across the first circulation electrode and passing through the central light emitting cell.

The second common electrode 250 may include a second circulation electrode passing through the peripheral light emitting cells and a second connection electrode connecting across the second circulation electrode and passing through the central light emitting cell.

The second circulation electrode may be disposed in the outside of the first circulation electrode. The first connection electrode and the second connection electrode may be vertically spaced apart and may be vertically crossed over the central light emitting cell. The second connection electrode may be crossed over the first connection electrode. The first and second circulation electrodes may have a square ring or circular ring shape, without being limited to a specific shape.

In FIG. 9, K light emitting cells included in one subpixel (a light emitting device 200) may be connected in parallel between the first and second common electrodes 240 and 250, and accordingly, even when one light emitting cell is not turned on, other light emitting cells may be normally turned on without being affected by this.

Meanwhile, the disclosed technology is not limited to the light emitting devices 200 configuring one pixel PX that emits light of different colors or light of different peak wavelengths, and each light emitting unit 210 configuring the light emitting device 200 may emit light of different colors. Alternatively, each light emitting device 200 may be configured by vertically stacking light emitting structures that emit light of different peak wavelengths. That is, it is also possible to have an example where each light emitting device 200 is vertically stacked and includes K light emitting units 210 that respectively emit red light, green light, and blue light.

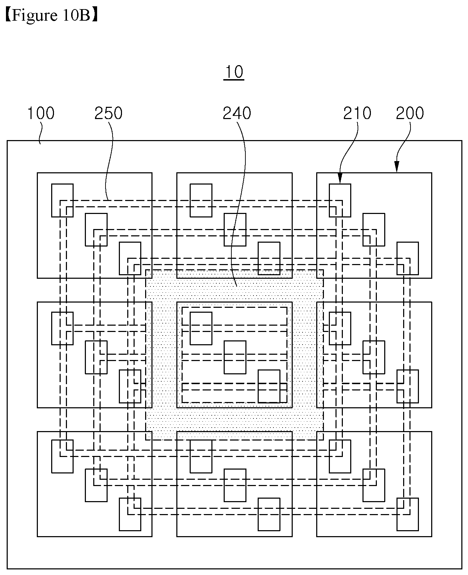

In addition, FIGs. 8 and 9 illustrate an example in which the K light emitting cells (the light emitting units 210) included in the one subpixel are connected in parallel by the first and second common electrodes 240 and 250, but, alternatively, as illustrated in FIGs. 10A to 10C, at least portions of the first and second common electrodes 240 and 250 may be shared with other light emitting devices 200. Hereinafter, embodiments of FIGs. 10A and 10B will be described in detail, focusing on differences from FIGs. 8 and 9.

FIG. 10A is a modified example of the light emitting apparatus 10 of FIGs. 8 and 9, in which, in the light emitting apparatus 10, each of four light emitting devices 200_1, 200_2, 200_3, and 200_4, which are subpixels, includes three light emitting cells, that is, three light emitting units 210_1, 210_2, and 210_3, and the light emitting units 210_1, 210_2, and 210_3 may be vertically stacked and disposed.

In a case of FIG. 10A, since at least portions of first common electrodes 240 are shared by adjacent light emitting devices 200, the first common electrodes 240 may be provided in a number less than a total number of light emitting devices 200. That is, while the total number of light emitting devices 200 in FIG. 10A is four, since the first common electrode 240 is shared by all light emitting devices 200, only one first common electrode 240 may be provided.

In addition, in the case of FIG. 10A, at least portions of second common electrodes 250 may be shared by light emitting units 210_1, 210_2, and 210_3 of other subpixels (light emitting devices 200).

Specifically, referring to FIG. 10A, the first common electrode 240 is an electrode that is commonly connected to first conductivity type semiconductor layers or second conductivity type semiconductor layers of the light emitting units 210_1, 210_2, and 210_3, which is shared by all light emitting devices 200, so that it may be provided as a single electrode, and may be a central electrode disposed in a center thereof. That is, unlike FIGs. 8 and 9, the first common electrode 240 is not provided for each light emitting device 200, but may be an electrode also shared with other light emitting devices 200.

In addition, in FIG. 10A, the second common electrode 250 is provided in a plurality of numbers and may not be a common electrode connecting the light emitting units 210 in one light emitting device 200, but may be a common electrode shared with light emitting units 210_1, 210_2, and 210_3 of other subpixels (light emitting devices 200).

That is, the second common electrode 250 may be a common electrode connecting light emitting units 210 that emit light of a same peak wavelength or a same color among the light emitting units 210 in the light emitting apparatus 10. That is, one of the second common electrodes 250 may be a common electrode connecting light emitting units 210 emitting red light among all light emitting units 210 in the light emitting apparatus 10, another one of the second common electrodes 250 may be a common electrode connecting light emitting units 210 emitting green light among all light emitting units 210 in the light emitting apparatus 10, and yet another one of the second common electrodes 250 may be a common electrode connecting light emitting units 210 emitting blue light among all light emitting units 210 in the light emitting apparatus 10.

The second common electrode 250 may be a square or circular ring-shaped electrode for electrically connecting the light emitting units 210, without being limited to a specific shape.

FIG. 10B is a modified example of FIG. 10A, and may be configured identically or similarly to FIG. 10A, except that the light emitting apparatus 10 includes nine light emitting devices 200 disposed in a 3x3 matrix form.

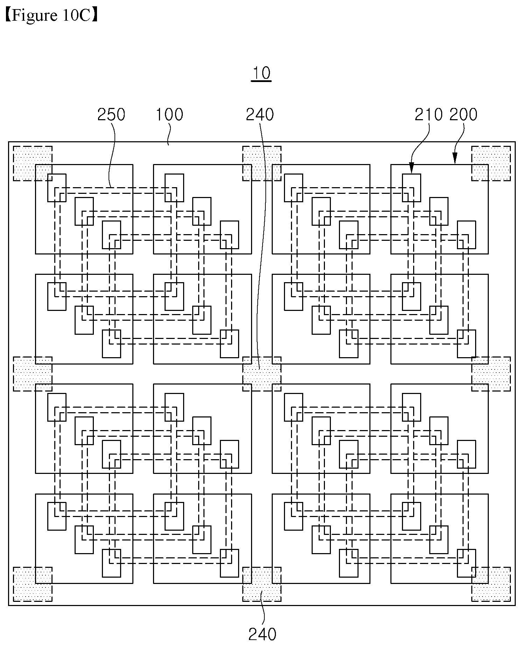

FIG. 10C is a modified example of FIGs. 10A and 10B, and may be configured identically or similarly to FIGs. 10A and 10B, except that the light emitting apparatus 10 includes nine light emitting devices 200 disposed in a 4x4 matrix form and a plurality of first common electrodes 240 is provided.

The first common electrode 240 may be shared with adjacent light emitting devices 200. The plurality of first common electrodes 240 may be disposed along a central region and edge of a substrate 100.

The second common electrode 250 may also be provided in a plurality of numbers, and unlike FIGs. 10A and 10B, one common electrode 250 may not connect all light emitting units 210 emitting light of a same peak wavelength or color within the light emitting apparatus 10, but may connect portions of all light emitting units 210 emitting light of the same peak wavelength or color within the light emitting apparatus 10. Remaining light emitting units 210 may be connected by another second common electrode 250. That is, the portions of the light emitting units 210 emitting light of the same peak wavelength or color may be connected to different second common electrodes 250.

A plurality of light emitting units 210 included in the light emitting apparatus 10 of the disclosed technology may be electrically connected by the first common electrode 240 and the second common electrode 250. In this case, the plurality of light emitting units 210 may be connected in parallel. Accordingly, even when one light emitting unit 210 is not turned on, other light emitting units may be turned on without being affected by this. In addition, even when one light emitting unit 210 is not turned one, since a corresponding color may be emitted from the other light emitting units 210, a color change rate for non-lighting may be reduced.

Although the disclosed technology has been described above with reference to preferred embodiments thereof, it will be understood by those skilled in the art or having ordinary knowledge in the art that various modifications and changes may be made to the disclosed technology without departing from the scope of the spirit and technical field of the disclosed technology as set forth in the scope of the patent claims below.

Accordingly, the technical scope of the disclosed technology should not be limited to the contents described in the detailed description of the specification, but should be defined by the scope of the patent claims.

## Claims

1. A light emitting apparatus 10, comprising a substrate 100 and a plurality of light emitting devices 200 disposed on the substrate 100, and
at least one substrate common electrode 110 and a plurality of substrate individual electrodes 120 formed on the substrate 100,
wherein N light emitting devices 200₁~200_{N} (N is a natural number greater than or equal to 2) is commonly connected to the substrate common electrode 110 to form a light emitting group G.

2. The light emitting apparatus 10 of claim 1,
wherein a number of the substrate common electrodes 110 is equal to a number of the light emitting groups G.

3. The light emitting apparatus 10 of claim 1,
wherein the light emitting device 200 includes K light emitting units 210₁~210_{K} (K is a natural number greater than or equal to 2), a common electrode 220 commonly connected to the K light emitting units 210₁~210_{K}, and a plurality of individual electrodes 230 connected to each of the K light emitting units 210₁~210_{K}.

4. The light emitting apparatus 10 of claim 3,
wherein the N is greater than or equal to the K.

5. The light emitting apparatus 10 of claim 3,
wherein a number of the plurality of individual electrodes 230 is K.

6. The light emitting apparatus 10 of claim 3,
wherein the N is greater than the K and less than or equal to twice the K.

7. The light emitting apparatus 10 of claim 3,
wherein the K light emitting units 210₁~210_{K} emit light of a same peak wavelength.

8. The light emitting apparatus 10 of claim 3,
wherein at least one of the K light emitting units 210₁~210_{K} emits light of a peak wavelength different from other light emitting units 210₁~210_{K}.

9. The light emitting apparatus 10 of claim 1,
wherein the N light emitting devices 200₁~200_{N} are disposed to surround the substrate common electrode 110 with the substrate common electrode 110 as a center.

10. The light emitting apparatus 10 of claim 1,
wherein the N light emitting devices 200₁~200_{N} are disposed with virtual extension lines V as a boundary, which are radially branched from the substrate common electrode 110 as a center.

11. The light emitting apparatus 10 of claim 9, wherein:
the N light emitting devices 200₁~200_{N} have a polygonal shape in plan view, and
virtual lines IM connecting vertices positioned farthest from the substrate common electrode 110 among vertices of the light emitting devices 200₁~200_{N} form a triangle, a square, a pentagon or a hexagon in plan view.

12. The light emitting apparatus 10 of claim 9, wherein:
the N light emitting devices 200₁~200_{N} have a polygonal shape in plan view, and
at least a portion of a region formed by virtual lines IM connecting edges positioned farthest from the substrate common electrode 110 among edges of the light emitting devices 200₁~200_{N} is overlapped with the light emitting devices 200₁~200_{N} of an adjacent light emitting group G in plan view.

13. A light emitting apparatus 10, comprising a substrate 100 and a plurality of light emitting devices 200 disposed on the substrate 100,
wherein the light emitting device 200 has K light emitting units 210₁~210_{K} (K is a natural number greater than or equal to 2), and a first common electrode 240 commonly connected to the K light emitting units 210₁~210_{K}.

14. The light emitting apparatus 10 of claim 13, further comprising:
a second common electrode 250 commonly connected to the K light emitting units 210₁~210_{K},
wherein the K light emitting units 210₁~210_{K} are connected in parallel between the first common electrode 240 and the second common electrode 250.

15. The light emitting apparatus 10 of claim 13,
wherein S light emitting devices 200₁~200_{S} form one pixel PX.

16. The light emitting apparatus 10 of claim 15,
wherein the S light emitting devices 200₁~200_{S} emit light of different peak wavelengths from one another.

17. The light emitting apparatus 10 of claim 16, wherein:
the pixel PX is provided in a plurality of numbers, and
an intensity of light having a first peak wavelength emitted from light emitting devices 200₁~200_{S} included in at least one of the plurality of pixels PX is different from that of light having the first peak wavelength emitted from light emitting devices 200₁~200_{S} included in other pixel PX.

18. The light emitting apparatus 10 of claim 16, wherein:
the pixel PX is provided in a plurality of numbers, and
a number of light emitting units 210₁~210_{K} emitting light having the first peak wavelength in the light emitting devices 200₁~200_{S} included in at least one of the plurality of pixels PX may be different from that of light emitting units 210₁~210_{K} emitting light having the first peak wavelength in light emitting devices 200₁~200_{S} included in other pixel PX.

19. The light emitting device 200 of the light emitting apparatus 10 of claim 13, comprising:
K light emitting units 210₁~210_{K} (K is a natural number greater than or equal to 2), and a first common electrode 240 commonly connected to the K light emitting units 210₁~210_{K}.

20. The light emitting device 200 of claim 19, further comprising:
a second common electrode 250 commonly connected to the K light emitting units 210₁~210_{K},
wherein the K light emitting units 210₁~210_{K} are connected in parallel between the first common electrode 240 and the second common electrode 250.
